# EUROPÄISCHE PATENTSCHRIFT

(11) **EP 2 027 604 B1**
(45) Veröffentlichungstag und Bekanntmachung des Hinweises auf die Patenterteilung: **13.02.2013**
(21) Anmeldenummer: 07722300.6
(22) Anmeldetag: 26.04.2007
(51) Int. Cl.: H01L 31/048, H05K 7/20, H01L 31/05

(54) **Verbindungsbox zum Schutz von einzelnen Solar-Panels vor Überhitzung**
Junction box to protect individual solar panels from overheating
Boîte de jonction pour protéger des panneaux solaires individuels de la surchauffe

(30) Priorität: 09.06.2006 DE 102006027104
(43) Veröffentlichungstag der Anmeldung: 25.02.2009
(73) Patentinhaber: FPE Fischer GmbH, 88299 Leutkirch (DE)
(72) Erfinder: FISCHER, Ulrich, 88299 Leutkirch-Gebrazhofen (DE); PFEFFER, Roland, 88299 Leutkirch (DE); WILLER, Bernd, 85368 Moosburg/Isar (DE); HSU, Charles, Tao Yuan Hsien (TW)
(74) Vertreter: Kaufmann, Sigfrid
(86) Internationale Anmeldenummer: PCT/DE2007/000742
(87) Internationale Veröffentlichungsnummer: WO 2007/140736

(56) Entgegenhaltungen:
- DE-A1- 3 703 088
- DE-A1- 19 609 243
- DE-A1-102005 022 226
- DE-U1-202005 007 592
- JP-A- 10 004 281
- JP-A- 2001 274 577
- JP-A- 2005 033 229
- JP-A- 2006 073 990
- US-A- 5 321 582

## Beschreibung

Die Erfindung betrifft eine Verbindungsbox, mit der die in den Schutzdioden eines Solar-Panels erzeugte Wärme gut abgeleitet wird.

Nach dem Stand der Technik findet man in Solaranlagen Solar-Panels unterschiedlicher Größe wobei diese dadurch bestimmt wird, wie viele Solarzellen in Reihe geschaltet sind. In großen Panels werden wiederum mehrere Zellenreihen in Reihe geschaltet. Jede Zellenreihe ist mit einer in Sperrrichtung betriebenen Schutzdiode gebrückt. Meist wird hierfür eine Schottky-Diode verwendet, da der Spannungsabfall in Durchlassrichtung geringer ist als bei einer herkömmlichen Silizium-Diode.

Beim Betrieb der Solarzellen kommt es allerdings vor, dass einzelne Solarzellen abgeschattet werden. Die Folge ist, dass die Schutzdiode leitend wird, da in diesem Fall an der Kathode ein niedrigeres elektrisches Potential herrscht.

Ohne die Schutzdiode entstünde durch den so genannten Zener-Effekt in der abgeschatteten Solarzelle eine hohe Verlustleistung, die zu einem "Hot Spot" in der Zelle und damit fast immer zur Zerstörung derselben führt. Die Solar-Panels sind ihrerseits wiederum in Reihe geschaltet, so dass eine entsprechend hohe Gleichspannung bei erzielbaren Strömen bis sechs Ampere auf einen Wechselrichter gelangt, der die zur Einspeisung in das öffentliche Stromnetz erforderliche Wechselspannung erzeugt.

Meist sind die Wechselrichter mit einem Kommunikationsmodul ausgestattet, um z.B. die Abgabeleistung der Solaranlage direkt per Anzeige oder rechnergestützt zu überwachen. Das Kommunikationsmodul bietet auch die Möglichkeit der Fernabfrage, z. B. per Telefon oder Internet.

Die über den Zellenreihen angeordneten Schottky-Dioden sind sehr wichtige Bauelemente, da sie bei Abschaltung die jeweilige Zellenreihe brücken und somit gewährleisten, dass der von den nicht beschatteten Zellen erzeugte Strom weiterhin fließt, ohne dass die Gefahr der Zerstörung der Solarzelle besteht. Der Spannungsabfall über den in Durchlassrichtung betriebenen Dioden ist mit ca. 0,3 bis 0,5 V vergleichsweise gering.

Übertemperatur und hohe Feldstärken, wie z. B. in Folge eines Blitzeinschlages, führen zur Zerstörung der Dioden. Im Fehlerfall kann die Diode entweder öffnen, d. h., zwischen Anode und Kathode entsteht eine Unterbrechung, oder die Diode kann kurzschließen, indem Anode und Kathode durch "Lichtbogen-Verschweißung" miteinander verschmelzen.

Bei kurzgeschlossener Diode fällt im Betrieb lediglich die betroffene Zellenreihe aus, es entsteht ein Leistungsabfall, der bei Verwendung vieler Panels allerdings praktisch kaum ins Gewicht fällt. Öffnet jedoch die Diode, so ist zunächst im Betrieb nichts davon zu merken, wenn die Zellenreihe genügend Leistung liefert. Findet dagegen eine Abschattung statt, so kann die Diode nicht mehr leiten, es entsteht in der abgeschatteten Zelle ein "Hot Spot", der zur Zerstörung der Zelle führen kann.

Bislang wird nur die Abgabeleistung der kompletten Solaranlage überwacht, jedoch nicht die der einzelnen Panels. Im Fehlerfall, d.h. bei Absinken der Leistung der Solaranlage, muss also Panel um Panel geprüft werden, bis der defekte Pfad gefunden ist. Je nach örtlicher Gegebenheit ist dies zeitraubend und mühsam und sowie ggf., z. B. bei Arbeiten auf einem Dach, gefährlich. Deshalb ist bei einer großen Solaranlage die Reparatur meist aufwändig und folglich teuer.

Der für die Solar-Panels gefährlichere Fall des Ausfalls von Schutzdioden auf Grund von Unterbrechung wird derzeit nicht überwacht. Die Folge ist, dass ein solcher Ausfall der Schutzdioden oft die Zerstörung der kostenintensiven Solarzellen verursacht.

Neben der Überwachung der Funktion der Schutzdioden ist es für einen sicheren Betrieb und zur Erreichung einer hohen Lebensdauer der Solar-Panels wichtig, dass die Schutzdioden vor thermischer Überlastung geschützt werden. Es ist nämlich so, dass die Schutzdioden bei Abschattung der Solarzellen große Leistungen aufnehmen müssen, d.h. sie erwärmen sich sehr stark. Werden die Dioden schlecht oder gar nicht gekühlt, so führt dies im Extremfall zu sofortigen Ausfällen; in jedem Fall wird bei übermäßiger Erwärmung die Lebensdauer der Dioden nachhaltig verringert. Dem entgegen ist es jedoch noch üblich, die Dioden ohne besondere Maßnahmen zur Wärmeableitung zu betreiben, wobei in der Praxis ausschließlich Kunststoffgehäuse, die die Wärme nur schlecht ableiten, verwendet werden.

In DE 100 50 614 C1 wird deshalb vorgeschlagen, die Schutzdioden mit der Innenseite eines die Wärme besser leitenden Metallgehäuses, dessen Außenseiten zudem Kühlrippen aufweisen können, zu verschrauben. Es wird jedoch keine Lehre angegeben, wie die elektrische Isolation der Dioden gegenüber dem Gehäuse erfolgt. Da jedoch bei praktisch allen Dioden immer entweder die Kathode oder die Anode mit der metallischen Seite des Diodengehäuses verbunden ist, würde die aufgezeigte Lösung zwangsläufig einen Kurzschluss unter den Schutzdioden verursachen. Hinzu kommt, dass sich die vorgeschlagene Verschraubung der Dioden unter dem Einfluss von Temperaturschwankungen und der dadurch bedingten Krümmung der Metallseite der Dioden lockert, was zur Folge hat, dass der thermische Kontakt zwischen Gehäuse und Diode unterbrochen wird. Des Weiteren kann bei einem Defekt von Bauteilen in der Box diese nicht geöffnet, repariert oder demontiert werden, da sie verklebt und ausgegossen ist. Nachteilig ist auch, dass das Modul zu hoch baut, und deshalb bei dem heutzutage verwendeten Montageaufbau nicht zwischen Solarmodul und Dach passt; zudem ist die Anschlussdurchführung in axialer Richtung angebracht, wofür ebenfalls der Platz fehlt. Auf Grund dieser Nachteile blieb die vorgeschlagene Lösung papierner Stand der Technik.

Des Weiteren wird in DE 10 2004 036 697 A1 ein Anschlusskasten für Solarzellen-Panels beschrieben, der sich dadurch auszeichnet, dass seine Bodenplatte aus hochwärmeleitendem Material hergestellt und zwischen dieser und der Schutzdiode eine elektrisch isolierende Schicht vorgesehen ist. Aber auch damit wird das oben aufgezeigte Problem, nämlich die ständige Gewährleistung eines sicheren Kontaktes zwischen Gehäuse und Diode nicht gelöst.

Der Erfindung liegt die Aufgabe zugrunde, die Nachteile des Standes der Technik zu beseitigen; insbesondere ist eine Verbindungsbox zum Schutz von einzelnen Solar-Panels vor Überhitzung zu schaffen.

Diese Aufgabe wird erfindungsgemäß durch die kennzeichnenden Merkmale des Anspruches 1 gelöst. Weitere vorteilhafte Ausführungen ergeben sich aus den Ansprüchen 2 bis 3.

Für die Verbindungsbox wird ein Gehäuse aus Metall, vorzugsweise aus Aluminium, verwendet. An einer oder an mehreren Seiten des Gehäuses können dabei Kühlrippen ausgeformt sein. Die darin eingebauten Dioden, MOSFETs oder entsprechenden Leistungshalbleiter werden durch Andruckelemente, erfindungsgemäß Federn, direkt an die innenliegende Gehäusewand oder in sich darin befindende Aussparungen gepresst, die der Form der Leistungshalbleiter entsprechen. Die elektrischen Anschlüsse der Leistungshalbleiter sind hierbei vom Gehäuse elektrisch isoliert. Eine einfach zu realisierende und kostengünstige und in Folge dessen bevorzugte Variante besteht darin, die Dioden mittels eines Federbügels in Nuten zu pressen, die in die innere Gehäusewand eingelassen sind. Die elektrische Isolation wird durch Mittel wie Kunststoff- oder Keramikblättchen oder Kunststofffolien vorgenommen. Versuche zeigten, dass thermisch leitender Silicongummi hierfür besonders geeignet ist. Der Silicongummi zeichnet sich durch außergewöhnliche Formanpassungsfähigkeit aus und gewährleistet eine hervorragende Wärmeabfuhr auch bei sehr unebenen Wärmeabfuhrflächen der Bauelemente.

Durch die somit erreichte bessere Kühlung werden vorzeitige Ausfälle der Schutzdioden verhindert. Insbesondere ist die Gefährdung der Solar-Panels infolge des Ausfalls von Dioden durch Unterbrechung verringert; gleichzeitig reduzieren sich die Ausfallzeiten und der Wartungsaufwand. Schließlich wird die Gefahr der Leistungsminderung der Solaranlage bei Ausfall von Dioden durch Kurzschluss minimiert. Sind weitere Schaltungselemente im selben Gehäuse untergebracht, so profitieren auch diese von der besseren Wärmeableitung.

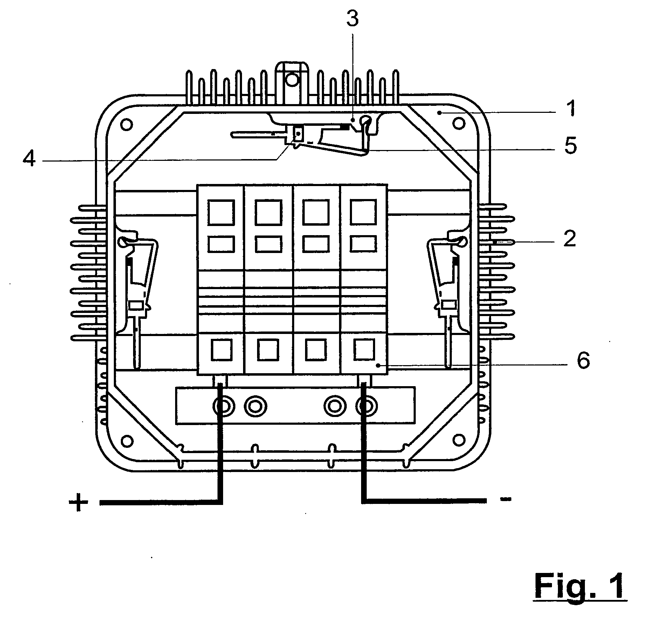

Die Erfindung wird nachfolgend anhand eines Ausführungsbeispiels näher erläutert; hierzu zeigt Fig. 1 die Verbindungsbox.

Die in Fig. 1 dargestellte Verbindungsbox besteht aus einem Gehäuse 1 aus Metall, an dessen Außenwänden Kühlrippen 2 ausgeformt sind. An den Innenseiten des Gehäuses 1 befinden sich die Aufnahmen 3, in welche jeweils eine Schottky-Diode 4 mit Hilfe eines Federbügels 5 gepresst wird. Zudem ist der Anschlussblock 6 zu sehen.

Zwischen der Diode 4 und dem Gehäuse 1 befindet sich eine thermisch leitende, jedoch elektrisch isolierende Schicht, ausgeführt als thermisch leitender Silicongummi. Durch diesen Aufbau werden die Dioden 4 vor Zerstörung durch Überhitzung geschützt.

Der innere Anschlussblock 6 ist, um die elektrische Durchschlagfestigkeit in dessen Bereich zu erhöhen, mit einer Kunststoffummantelung versehen. Damit ist sichergestellt, dass die diesbezüglichen, immer strenger werdenden Sicherheitsanforderungen auch in Zukunft problemlos erfüllt werden.

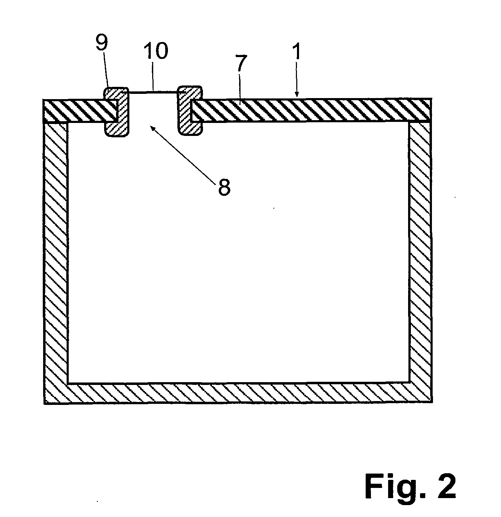

Wie in Fig. 2 dargestellt befindet sich im Gehäusedeckel 7 eine runde Öffnung 8. In diese ist ein aus flexiblem und witterungsbeständigem Silikongummi bestehender Halterungsring 9 eingebracht, in den eine wasserdichte aber luftdurchlässige Membran 10 eingeschweißt sind. Der Ring 9 ist mit leichtem Druck eingesetzt, d. h. der Silikongummi liegt an den Kontaktstellen zum Gehäusedeckel 7 immer mit leichtem Druck an. Dadurch wird eine gasdichte Verbindung in einfacher Weise gewährleistet; außerdem können der Ring 9 und die Membran 10 ohne großen Aufwand ausgetauscht werden, wenn sich z. B. die Membran 10 durch Staub oder andere Partikel zugesetzt hat.

Die Membran 10 hat einen Durchmesser von ca. 4 mm. Bei diesem Durchmesser sind für kleine bis mittelgroße Gehäuse eine optimale Belüftung und dementsprechend eine sichere Abführung von Feuchtigkeit aus dem Gehäuse gewährleistet. Bei größeren Gehäusen ist es jedoch auch denkbar, mehrere solcher Belüftungsöffnungen, vorzugsweise in gegenüberliegenden Seiten des Gehäuses, einzubringen.

Sind zusätzliche Schaltungen, wie z.B. Meldesysteme per Funk oder Bussysteme, im selben Gehäuse untergebracht, so profitieren auch diese von den besseren thermischen Eigenschaften und der Belüftung des Gehäuses 1. Das Gehäuse 1 wird üblicherweise direkt an dem zu schützenden Panel angebracht.

### Liste der verwendeten Bezugszeichen

- 1: Gehäuse
- 2: Kühlrippen
- 3: Aufnahme für Schottky-Diode
- 4: Schottky-Diode
- 5: Federbügel
- 6: Anschlussblock
- 7: Gehäusedeckel
- 8: Öffnung
- 9: Halterungsring
- 10: Membran

## Patentansprüche

1. Verbindungsbox für Solar-Panels, bestehend aus einem Gehäuse aus Metall (1) mit außen liegenden Kühlrippen (2), in der Schutzdioden (4), MOSFETs oder sonstige entsprechende Leistungshalbleiter eingebracht sind, **dadurch gekennzeichnet, dass** die elektronischen Bauteile durch jeweils einen Federbügel (5) als Druckelement in jeweils eine in das Gehäuse (1) eingelassene Nut (3), die der Geometrie des Bauteils entspricht, gepresst sind und sich zwischen dem Gehäuse (1) und den Bauteilen eine elektrische Isolation befindet.

2. Verbindungsbox nach Anspruch 1, **dadurch gekennzeichnet, dass** die elektrische Isolation durch ein Kunststoff- oder Keramikblättchen oder eine Kunststofffolie realisiert ist.

3. Verbindungsbox nach Anspruch 1 und 2, **dadurch gekennzeichnet, dass** die elektrische Isolation durch einen thermisch leitfähigen Silikongummi erfolgt.

## Claims

1. A junction box for solar panels, consisting of a housing made of metal (1) with outer cooling ribs (2), in which protective diodes (4), MOSFETs or other suitable power semiconductors are introduced, **characterised in that** the electronic components are each pressed by a respective spring clip (5) in the form of a pressing element into a respective groove (3) formed in the housing (1), said groove corresponding to the geometry of the component, and an electrical insulation is located between the housing (1) and the components.

2. The junction box according to Claim 1, **characterised in that** the electrical insulation is formed by a plastic or ceramic lamina or a plastic film.

3. The junction box according to Claims 1 and 2, **characterised in that** the electrical insulation is produced by a thermally conductive silicone rubber.

## Revendications

1. Boîtier de raccordement pour panneaux solaires, constitué d'un boîtier métallique (1) avec des nervures de refroidissement extérieures (2), dans lequel sont intégrés des diodes de protection (4), des MOSFET ou d'autres semiconducteurs correspondants, **caractérisé en ce que** les pièces électroniques sont pressées respectivement dans une rainure (3), prévue dans le boîtier (1) et correspondant à la géométrie de la pièce, par un étrier à ressort (5) respectif en tant qu'élément de pression, et **en ce qu'**une isolation électrique est prévue entre le boîtier (1) et les composants.

2. Boîtier de raccordement selon la revendication 1, **caractérisé en ce que** l'isolation électrique est réalisée par une pastille en plastique ou en céramique, ou par un film plastique.

3. Boîtier de raccordement selon les revendications 1 et 2, **caractérisé en ce que** l'isolation électrique est réalisée à l'aide d'un caoutchouc de silicone thermiquement conducteur.
